# EUROPEAN PATENT APPLICATION

(11) **EP 4 664 717 A1**
(43) Date of publication of application: **17.12.2025**
(21) Application number: 24779534.7
(22) Date of filing: 14.03.2024
(51) Int. Cl.: H02J 7/00

(54) **INFORMATION PROCESSING METHOD, INFORMATION PROCESSING DEVICE, AND INFORMATION PROCESSING PROGRAM**

(30) Priority: 24.03.2023 JP 2023048648
(71) Applicant: Panasonic Intellectual Property Management Co., Ltd., Kadoma-shi, Osaka 571-0057 (JP)
(72) Inventor: HAYASHI, Yuki, Kadoma-shi, Osaka 571-0057 (JP); NAGASHIMA, Tatsumi, Kadoma-shi, Osaka 571-0057 (JP); HIRATA, Yuki, Kadoma-shi, Osaka 571-0057 (JP)
(74) Representative: Grünecker Patent- und Rechtsanwälte PartG mbB
(86) International application number: PCT/JP2024/010082
(87) International publication number: WO 2024/203405

(57) **Abstract**

An information terminal acquires a plurality of error items indicating an error that has occurred in each of a plurality of batteries determined on the basis of an operation history of a plurality of state items indicating a plurality of states of the plurality of batteries, when selection of one error item of one battery among the plurality of error items having been acquired is received, acquires a related state item indicating a state item related to the one error item selected from among the plurality of state items of the one battery, and displays an operation history of the related state item having been acquired.

## Description

### Technical Field

The present disclosure relates to a technique of displaying an operation history of a battery in which an error has occurred.

### Background Art

For example, Patent Literature 1 discloses that a battery that is abnormally deteriorated is diagnosed from an operating history and a model of the battery, and a coefficient of an item that is out of a constraint condition is displayed in a highlighted manner.

Since there is a plurality of types of errors in the battery, a manager needs to confirm not only an item determined to be abnormal but also other item related to the item.

However, in the conventional technique described above, only an item determined to be abnormal is displayed in a highlighted manner, and further improvement is required.

### Citation List

### Patent Literature

Patent Literature 1: JP 2018-169161 A

### Summary of Invention

The present disclosure has been made to solve the above problem, and an object of the present disclosure is to provide a technique capable of supporting a user's confirmation as to whether a determination result of an error that has occurred in a battery is correct.

An information processing method of the present disclosure is an information processing method in a computer and includes acquiring a plurality of error items indicating an error that has occurred in each of a plurality of batteries determined on the basis of an operation history of a plurality of state items indicating a plurality of states of the plurality of batteries, when the selection of one error item of one battery among the plurality of error items having been acquired is received, acquiring a related state item indicating a state item related to the one error item having been selected from among the plurality of state items of the one battery, and displaying an operation history of the related state item having been acquired.

The present disclosure can support a user's confirmation as to whether a determination result of an error that has occurred in a battery is correct.

### Brief Description of Drawings

FIG. 1 is a diagram illustrating an overall configuration of a battery management system in an embodiment of the present disclosure.
FIG. 2 is a sequence diagram for describing an operation of the battery management system in the embodiment of the present disclosure.
FIG. 3 is a diagram illustrating an example of an error item display screen displaying a list of a plurality of error items in the present embodiment.
FIG. 4 is a diagram illustrating an example of an error item display screen displaying a list of a plurality of error items in Modification 1 of the present embodiment.
FIG. 5 is a diagram illustrating an example of an error item display screen displaying a list of a plurality of error items in Modification 2 of the present embodiment.
FIG. 6 is a diagram illustrating an example of a related state item display screen displaying an operation history of a related state item in the present embodiment.
FIG. 7 is a flowchart for describing error determination processing of a server in an embodiment of the present disclosure.
FIG. 8 is a flowchart for describing related state item extraction processing of the server in the embodiment of the present disclosure.
FIG. 9 is a diagram illustrating an example of a related state item table stored in advance in a memory in the present embodiment.
FIG. 10 is a diagram illustrating another example of the related state item table stored in advance in the memory in the present embodiment.
FIG. 11 is a flowchart for describing table update processing of the server in an embodiment of the present disclosure.
FIG. 12 is a schematic diagram for describing update of the related state item table in the present embodiment.
FIG. 13 is a flowchart for describing related state item extraction processing of the server in Modification 3 of the embodiment of the present disclosure.
FIG. 14 is a diagram illustrating an example of a related state item display screen displaying an operation history of a related state item in Modification 3 of the present embodiment.

### Description of Embodiments

### (Knowledge Underlying Present Disclosure)

When an error occurs in a battery, even if the name of the error is presented to a manager, the manager cannot know the cause of the occurrence of the error and a determination criterion of the error only by viewing the name of the error. There is a possibility that the device that measures the state of the battery has an abnormality, and there is a possibility that a measured value has an abnormality.

As described above, in the conventional technique, only the item determined to be abnormal is displayed in a highlighted manner. It has been therefore difficult to support a user's confirmation as to whether a determination result of the error that has occurred in the battery is correct, and to support the manager to better understand the cause of the error that has occurred in the battery.

In order to solve the above problem, the following technique is disclosed.
(1) An information processing method according to an aspect of the present disclosure is an information processing method in a computer, the method including acquiring a plurality of error items indicating an error that has occurred in each of a plurality of batteries determined on a basis of an operation history of a plurality of state items indicating a plurality of states of the plurality of batteries, when selection of one error item of one battery among the plurality of error items having been acquired is received, acquiring a related state item indicating a state item related to the one error item having been selected from among the plurality of state items of the one battery, and displaying an operation history of the related state item having been acquired.

In this configuration, the operation history of the related state item indicating the state item related to the determined one error item among the plurality of state items of one battery is displayed.

Therefore, the user who is the manager of the plurality of batteries can determine whether the determination result of the error that has occurred in the battery is correct by viewing the operation history of the related state item related to the determined one error item. It is therefore possible to support the user's confirmation as to whether the determination result of the error that has occurred in the battery is correct.

In the conventional technique, only the operation history of the abnormal state item is displayed in a highlighted manner. In the conventional technique, in order to display the operation history of the related state item related to one error item for determine of whether the determination result of the error that has occurred in the battery is correct, it is necessary to display the operation history of all the state items of one battery and the condition used for the determination of the error after receiving the selection of one error item of the one battery by the user, to receive the selection of the state item related to the error item that has occurred in the battery by the user, to determine the state item to be displayed on the basis of the selection, and to display the operation history of the state item again. On the other hand, in the above configuration, when the selection of one error item of one battery is received, the operation history of the related state item related to the selected one error item is displayed. As a result, in the above configuration, the processing sequence can be omitted. Therefore, an effect of reducing computer resources is obtained by omitting the processing sequence.

(2) The information processing method according to (1) further may include acquiring the operation history of the plurality of state items of the one battery, in which in the displaying of the operation history, the operation history of the plurality of state items having been acquired is displayed, and the operation history of the related state item having been acquired is displayed in a mode different from an operation history of another state item other than the related state item.

In this configuration, since the operation history of the plurality of state items of one battery is displayed and the operation history of the related state item is displayed in a mode different from the operation history of another state item other than the related state item, the user can easily distinguish the related state item necessary for determining an error that has occurred in a battery from among the plurality of displayed state items of the one battery.

(3) In the information processing method according to (2), the related state item may include a first related state item indicating a state item that has caused error determination and a second related state item indicating a state item other than the first related state item, and in the displaying of the operation history, the operation history of the first related state item may be displayed in a mode different from the operation history of the second related state item.

In this configuration, the related state item includes a first related state item indicating a state item that has caused an error determination, and a second related state item indicating a state item other than the first related state item. The operation history of the first related state item is displayed in a mode different from the operation history of the second related state item.

Therefore, the user can better understand the cause of the error that has occurred in the battery by viewing the first related state item indicating the state item that has caused the error determination and the second related state item indicating the state item other than the first related state item. Thus, it is possible to support the user to better understand the cause of the error that has occurred in the battery.

(4) In the information processing method according to (3), in the displaying of the operation history, the operation history of the first related state item may be displayed to be larger than the operation history of the second related state item.

In this configuration, since the operation history of the first related state item is displayed to be larger than the operation history of the second related state item, the user can easily confirm what the state item that has caused the error determination is.

(5) In the information processing method according to (3) or (4), in the acquiring of the related state item, from a table in which each of the plurality of error items and a plurality of related state items are associated in advance, the first related state item and the second related state item other than the first related state item among the plurality of related state items associated with the one error item having been selected may be extracted, and the first related state item and the second related state item having extracted may be acquired.

In this configuration, since the first related state item and the second related state item other than the first related state item among the plurality of related state items associated with the one error item are extracted from the table, the first related state item indicating the state item that has caused the error determination of the one error item and the second related state item related to the one error item other than the first related state item can be easily specified.

(6) In the information processing method according to (5), further may include updating the table to change the current related state item to a new related state item, when a change of the related state item associated with the error item is received.

In this configuration, it is possible to delete an unnecessary related state item from the table and add a necessary related state item to the table when determining an error that has occurred in the battery.

(7) In the information processing method according to any one of (1) to (6), in the acquiring of the related state item, another battery similar to the one battery may be further specified among the plurality of batteries, and an operation history of a same state item as the related state item may be acquired among the plurality of state items of the other battery having been specified, and in the displaying of the operation history, the operation history of the related state item may be displayed, and the operation history of the same state item of the other battery as the related state item of the one battery may be displayed.

In this configuration, another battery similar to one battery is specified, the operation history of the related state item of the one battery is displayed, and the operation history of the state item of the other battery same as the related state item of the one battery is displayed. Therefore, since the operation history of the related state item of one battery can be presented to the user in comparison with the operation history of the state item of the other battery same as the related state item of the one battery, it is possible to support the user's confirmation as to whether the determination result of the error that has occurred in the one battery is correct.

(8) In the information processing method according to (7), in the specifying of the other battery, a battery in which an error of a same error item as the one battery has occurred or a battery in which an error of the same error item as the one battery has occurred in past may be specified as the other battery.

In this configuration, since a battery in which an error of the same error item as one battery has occurred or a battery in which an error of the same error item as the one battery has occurred in the past is specified as another battery, another battery similar to the one battery can be easily specified, and it is possible to support user's confirmation as to whether a determination result of an error that has occurred in the one battery is correct.

The present disclosure can be implemented not only as an information processing method for executing the characteristic processing as described above, but also as an information processing device or the like having a characteristic configuration corresponding to characteristic processing executed by the information processing method. The present disclosure can also be implemented as a computer program that causes a computer to execute characteristic processing included in the information processing method described above. Therefore, an effect similar to the effect in the above information processing method can also be achieved by another aspect described below.

(9) An information processing device according to another aspect of the present disclosure includes a first acquisition part that acquires a plurality of error items indicating an error that has occurred in each of a plurality of batteries determined on a basis of an operation history of a plurality of state items indicating a plurality of states of the plurality of batteries, a second acquisition part that, when selection of one error item of one battery among the plurality of error items having been acquired is received, acquires a related state item indicating a state item related to the one error item having been selected from among the plurality of state items of the one battery, and a display part that displays an operation history of the related state item having been acquired.

(10) An information processing program according to another aspect of the present disclosure causes a computer to function to acquire a plurality of error items indicating an error that has occurred in each of a plurality of batteries determined on a basis of an operation history of a plurality of state items indicating a plurality of states of the plurality of batteries, when selection of one error item of one battery among the plurality of error items having been acquired is received, acquire a related state item indicating a state item related to the one error item having been selected from among the plurality of state items of the one battery, and display an operation history of the related state item having been acquired.

(11) A computer-readable recording medium according to another aspect of the present disclosure records an information processing program, the information processing program causing a computer to function to acquire a plurality of error items indicating an error that has occurred in each of a plurality of batteries determined on a basis of an operation history of a plurality of state items indicating a plurality of states of the plurality of batteries, when selection of one error item of one battery among the plurality of error items having been acquired is received, acquire a related state item indicating a state item related to the one error item having been selected from among the plurality of state items of the one battery, and display an operation history of the related state item having been acquired.

Hereinafter, embodiments of the present disclosure will be described with reference to the accompanying drawings. Each of embodiments described below illustrates a specific example of the present disclosure. Numerical values, shapes, constituent elements, steps, order of steps, and the like of the embodiment below are merely examples, and do not intend to limit the present disclosure. A constituent element not described in an independent claim representing a highest concept among constituent elements in the embodiments below is described as an optional constituent element. In all the embodiments, respective contents can be combined.

### (Embodiments)

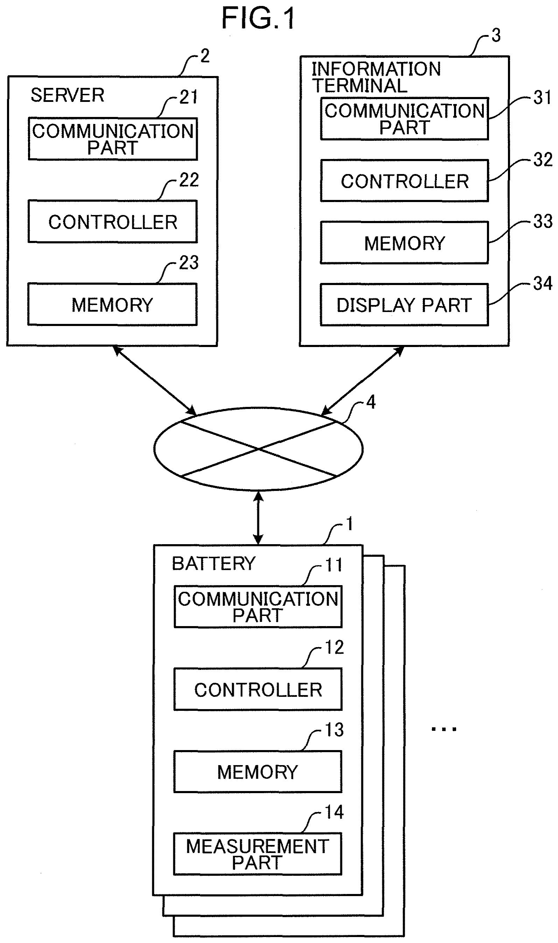

FIG. 1 is a diagram illustrating an overall configuration of a battery management system in an embodiment of the present disclosure.

The battery management system illustrated in FIG. 1 includes a plurality of batteries 1, a server 2, and an information terminal 3.

Each of the batteries 1 includes a plurality of secondary batteries, and stores electric power by charging, and supplies electric power by discharging. The secondary battery is, for example, a lead acid battery or a lithium ion battery. The battery 1 is a battery pack including a plurality of battery cells. The battery 1 is mounted as a power source on various devices. The battery 1 is mounted on an electric mobile body such as an electric vehicle, for example.

The battery 1 is not limited to an in-vehicle battery mounted on an electric mobile body, and may be a stationary storage battery, a fuel cell, or a solar cell used in an energy management business or the like.

The battery 1 includes a communication part 11, a controller 12, a memory 13, and a measurement part 14.

The measurement part 14 measures a plurality of state items of the battery 1. The measurement part 14 measures the plurality of state items such as a field effect transistor (FET) temperature, a cell temperature, a pack temperature, an ambient temperature, a cell current, a cell voltage, a pack current, a pack voltage, a pack resistance, the number of times of charging, a cumulative charge amount, a cumulative discharge amount, a pack full charge amount, and a state of charge (SOC). The measurement part 14 stores measured values of the plurality of state items in the memory 13. In a case where the battery 1 is a fuel cell or a solar cell, the pack current, the pack voltage, and the number of times of charging of the state items may be an output current, an output voltage, and the number of times of output.

The memory 13 is, for example, a storage device, such as a random access memory (RAM), a solid state drive (SSD), or a flash memory, capable of storing various types of information. The memory 13 stores an operation history of the plurality of state items measured by the measurement part 14.

The controller 12 is, for example, a central processing unit (CPU), reads the operation history of the plurality of state items from the memory 13, and creates battery log information including a battery ID for identifying the battery 1 and the read operation history of the plurality of state items. The controller 12 outputs the created battery log information to the communication part 11.

The communication part 11 transmits the battery log information of the battery 1 to the server 2. The battery log information includes a battery ID of the battery 1 and the operation history of the plurality of state items of the battery 1. The communication part 11 periodically transmits the battery log information to the server 2. For example, the communication part 11 may transmit the battery log information including the operation history of the plurality of state items measured for one minute to the server 2 every one minute.

Although the battery 1 includes the communication part 11, the controller 12, the memory 13, and the measurement part 14 in the present embodiment, the present disclosure is not limited to this configuration, and a device on which the battery 1 is mounted may include the communication part 11, the controller 12, the memory 13, and the measurement part 14.

The server 2 is communicably connected to the plurality of batteries 1 and the information terminal 3 via a network 4. The network 4 is the Internet, for example.

The server 2 includes a communication part 21, a controller 22, and a memory 23.

The communication part 21 receives the battery log information transmitted by the battery 1. The communication part 21 outputs the received battery log information to the controller 22.

The memory 23 is a storage device, such as a random access memory (RAM), a solid state drive (SSD), a hard disk drive (HDD), or a flash memory, capable of storing various types of information. The memory 23 stores the battery log information. The memory 23 stores the operation history of the plurality of state items in association with the battery ID. The memory 23 stores the operation history of the plurality of state items of each of the plurality of batteries 1.

The memory 23 stores a related state item table in which each of a plurality of error items indicating an error that has occurred in each of the plurality of batteries 1 and a related state item indicating the state item related to the error item are associated in advance.

The controller 22 is, for example, a CPU. The controller 22 stores the battery log information received by the communication part 21 in the memory 23.

The controller 22 determines an error that has occurred in each of the plurality of batteries 1 on the basis of the operation history of the plurality of state items indicating the plurality of states of the plurality of batteries 1. The error items indicating an error include a first fatal error related to current and voltage abnormality, a second fatal error related to battery life, a third fatal error related to activation failure, a fourth fatal error related to charger failure, a fifth fatal error related to communication abnormality, a high substrate temperature error, a cell low voltage error, a charging overheat error, a charge overcurrent error, and a high resistance error in which internal resistance increases. The controller 22 determines what type of error has occurred in each of the plurality of batteries 1.

In the present embodiment, the error items are classified into the first fatal error, the second fatal error, the third fatal error, the fourth fatal error, and the fifth fatal error, but the present disclosure is not limited to this classification. The controller 22 may generally determine an error as a fatal error if the error is determined on the basis of a combination of the state items.

In the present embodiment, the error items are classified into a high substrate temperature error, a cell low voltage error, a charging overheat error, a charge overcurrent error, and a high resistance error, but the present disclosure is not limited to this classification. For example, the controller 22 may simply determine an error as a battery state error or the like without classifying the error as the above errors. In addition to a cell high voltage error, the error item may include an error related to a function of an electric mobile body on which the battery 1 is mounted.

The controller 22 determines an error of each battery on the basis of a combination of at least one state item satisfying a predetermined determination criterion among the plurality of state items. For example, the controller 22 determines that the first fatal error has occurred when each of a pack state, the pack current, a cell balance, and the pack voltage satisfies a predetermined determination criterion among seven state items of the pack state, the pack current, the cell balance, the pack voltage, the number of times of charging, the cumulative discharge amount, and a system log.

The controller 22 may determine whether an abnormal value is detected in the operation history of the plurality of state items indicating the plurality of states of the plurality of batteries 1. Then, when an abnormal value is detected in the operation history of the plurality of state items, the controller 22 may determine that an error related to the state item in which the abnormal value is detected has occurred. The abnormal value indicates a value exceeding a threshold. The threshold varies depending on the state item. For example, when a substrate temperature, which is one of the state items, is higher than a threshold, the controller 22 determines that the high substrate temperature error has occurred.

The controller 22 outputs a plurality of error items indicating an error that has occurred in each of the plurality of batteries 1 to the communication part 21.

The communication part 21 transmits, to the information terminal 3, the plurality of error items indicating the error that has occurred in each of the plurality of batteries 1 determined by the controller 22.

The communication part 21 receives data request transmitted by the information terminal 3. The data request includes one error item of one battery selected by a user.

The controller 22 extracts a related state item indicating a state item related to one error item included in the data request from among a plurality of error items of one battery included in the data request received by the communication part 21. The related state item includes a first related state item indicating a state item that has caused an error determination, and a second related state item indicating a state item other than the first related state item. The controller 22 extracts the first related state item and the second related state item other than the first related state item from among the plurality of related state items associated with the selected one error item from the related state item table in which each of the plurality of error items and the plurality of related state items are associated in advance.

The communication part 21 transmits the related state item extracted by the controller 22 to the information terminal 3. The communication part 21 transmits the first related state item and the second related state item extracted by the controller 22 to the information terminal 3. The communication part 21 transmits the operation history of all of the plurality of state items of one battery included in the data request received by the communication part 21 to the information terminal 3.

When a change of the related state item associated with the error item is received, the controller 22 updates the related state item table stored in the memory 23 to change a current related state item to a new related state item.

The information terminal 3 is, for example, a smartphone, a tablet computer, or a personal computer, and is used by a manager who manages the plurality of batteries 1.

The information terminal 3 includes a communication part 31, a controller 32, a memory 33, and a display part 34.

The communication part 31 receives a plurality of error items transmitted by the server 2. The communication part 31 acquires a plurality of error items indicating an error that has occurred in each of the plurality of batteries 1 determined on the basis of the operation history of the plurality of state items indicating the plurality of states of the plurality of batteries 1.

The controller 32 is, for example, a CPU. The controller 32 controls the display part 34 to display a list of the plurality of error items received by the communication part 31.

The display part 34 is, for example, a touch panel, and displays a list of the plurality of error items received by the communication part 31. At this time, the display part 34 receives selection by the user of one error item of one battery among the plurality of error items received by the communication part 31.

The communication part 31 transmits a data request for requesting a related state item related to one error item of selected one battery to the server 2. The communication part 31 receives the error item transmitted by the server 2. When the selection of one error item of one battery among the plurality of acquired error items is received, the communication part 31 acquires a related state item indicating a state item related to the selected one error item among the plurality of state items of one battery. The communication part 31 receives the operation history of all of the plurality of state items of one battery transmitted by the server 2. That is, the communication part 31 acquires an operation history of a plurality of state items of one battery.

The memory 33 is, for example, a storage device that can store various types of information, such as a RAM, an SSD, an HDD, or a flash memory. The memory 33 stores the operation history of the plurality of state items of one battery received by the communication part 31.

The controller 32 controls the display part 34 to display the related state item received by the communication part 31. The display part 34 displays the operation history of the acquired related state item. Here, the display part 34 displays the acquired operation history of the plurality of state items of one battery, and displays the acquired operation history of the related state item in a different mode from the operation history of other state items other than the related state item.

The display part 34 may display the operation history of the first related state item indicating the state item that has caused the error determination in a mode different from the operation history of the second related state item indicating a state item other than the first related state item. The display part 34 may display the operation history of the first related state item to be larger than the operation history of the second related state item.

Although the battery management system in the present embodiment includes the plurality of batteries 1, the server 2, and the information terminal 3, the present disclosure is not limited to this configuration, and the battery management system may include the plurality of batteries 1 and the information terminal 3 without including the server 2. In this case, the information terminal 3 has a function of the server 2.

Next, an operation of the battery management system in the embodiment of the present disclosure will be described.

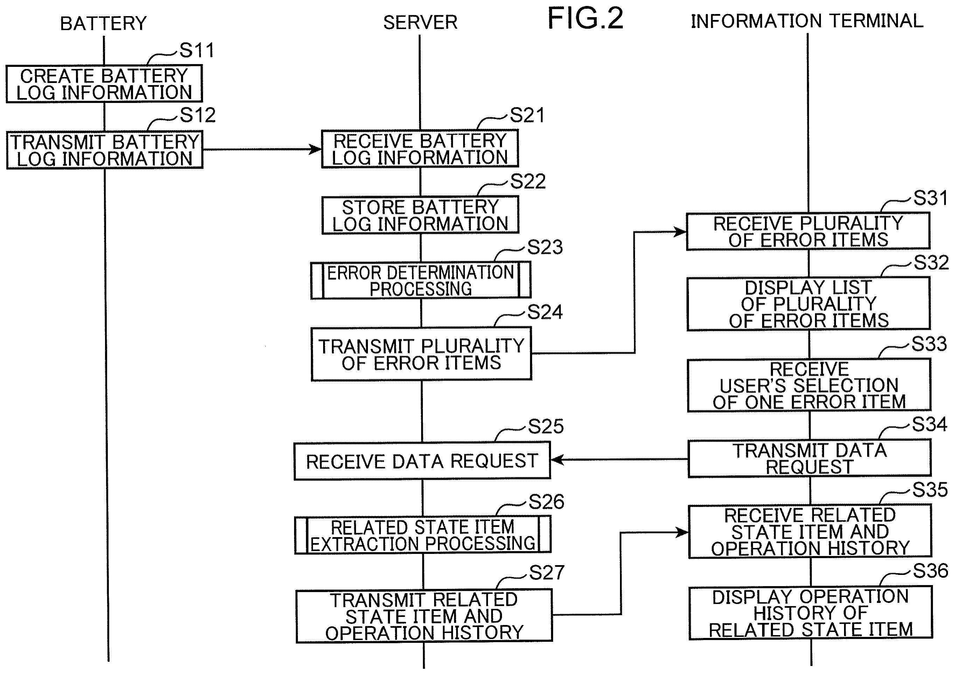

FIG. 2 is a sequence diagram for describing the operation of the battery management system in the embodiment of the present disclosure.

First, in step S11, the controller 12 of the battery 1 creates battery log information including the battery ID and the operation history of the plurality of state items.

Next, in step S12, the communication part 11 of the battery 1 transmits the battery log information of the battery 1 created by the controller 12 to the server 2. The battery management system includes a plurality of batteries 1. Therefore, each of the plurality of batteries 1 transmits the battery log information to the server 2.

Next, in step S21, the communication part 21 of the server 2 receives the battery log information transmitted by the battery 1. The communication part 21 receives a plurality of pieces of battery log information transmitted by the plurality of batteries 1.

Next, in step S22, the controller 22 of the server 2 stores the battery log information received by the communication part 21 in the memory 23. The controller 22 stores the battery log information of the plurality of batteries 1 in the memory 23.

Next, in step S23, the controller 22 executes error determination processing for determining what type of error has occurred on each of the plurality of batteries 1. Note that the error determination processing will be described later.

Next in step S24, the communication part 21 transmits, to the information terminal 3, the plurality of error items indicating the error that has occurred in each of the plurality of batteries 1. At this time, the controller 22 outputs, to the communication part 21, a plurality of error items of the plurality of batteries 1 for which it is determined that an error has occurred. Each of the plurality of error items is associated with an error item of any of the batteries.

A temporal range in which the plurality of error items is determined from the battery log information can be changed, and a change by the user may be accepted. For example, in a case where an error occurs in December, there is a high possibility that the data of March is unnecessary. Therefore, the controller 22 may determine a plurality of error items from the battery log information of the latest October to December.

Next, in step S31, the communication part 31 of the information terminal 3 receives a plurality of error items transmitted by the server 2.

Next, in step S32, the display part 34 displays a list of the plurality of error items received by the communication part 31.

Next, in step S33, the display part 34 receives selection by the user of one error item of one battery among the plurality of error items received by the communication part 31.

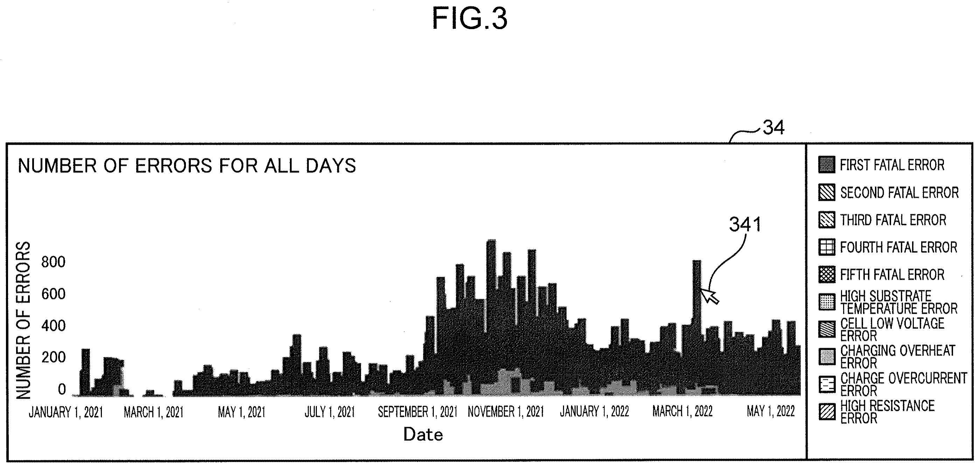

FIG. 3 is a diagram illustrating an example of an error item display screen displaying a list of a plurality of error items in the present embodiment.

The display part 34 displays the error item display screen illustrated in FIG. 3. The error item display screen includes a bar graph indicating the number of error items that have occurred in a predetermined period. The vertical axis represents the number of error items, and the horizontal axis represents day, month, and year. The bar graphs are stacked by being color-coded in accordance with the error item.

For example, the error items include the first fatal error, the second fatal error, the third fatal error, the fourth fatal error, the fifth fatal error, the high substrate temperature error, the cell low voltage error, the charging overheat error, the charge overcurrent error, and the high resistance error. Explanatory note for describing the colors corresponding to the error items are displayed next to the bar graph. For example, the color corresponding to the first fatal error is blue, the color corresponding to the second fatal error is red, the color corresponding to the third fatal error is green, and the color corresponding to the fourth fatal error is yellow.

The stacked bar graphs are selectable. For example, the user moves a pointer 341 on a screen by operating a mouse (not illustrated) and clicks on a desired bar graph. Alternatively, for example, in a case where the display part 34 is a touch panel, the user touches a desired bar graph. One error item of one battery is selected by selecting one point of a desired bar graph.

In the present embodiment, the display part 34 displays a list of a plurality of error items by stacked bar graphs, but the present disclosure is not limited to this display. In Modification 1 of the present embodiment, the display part 34 may display a list of the plurality of error items by a donut chart.

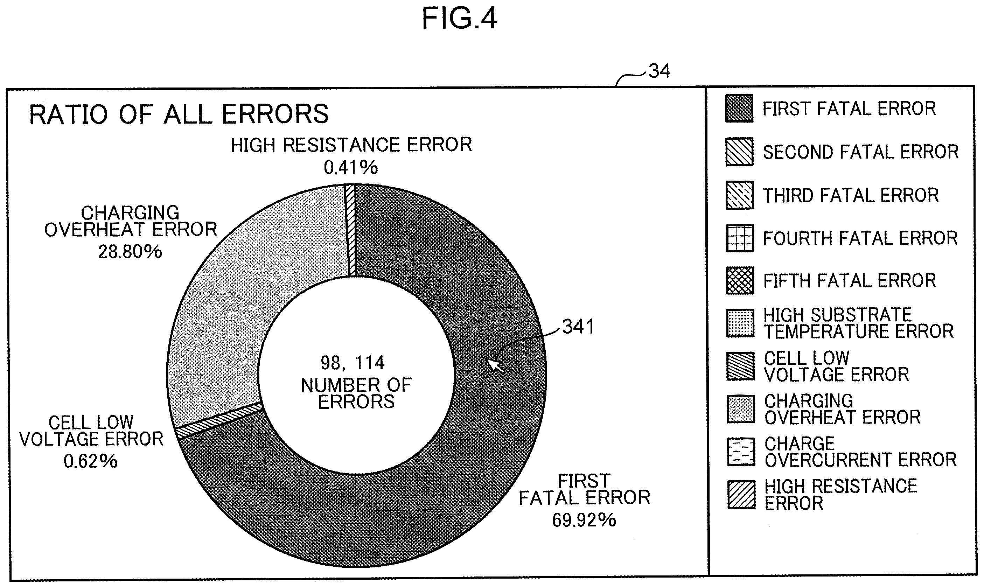

FIG. 4 is a diagram illustrating an example of an error item display screen displaying a list of a plurality of error items in Modification 1 of the present embodiment.

The display part 34 may display the error item display screen illustrated in FIG. 4. The error item display screen includes a donut chart indicating a ratio of each error item to a total number of error items in which an abnormality has occurred during a predetermined period. The donut chart is color-coded in accordance with the error items, and represents a ratio of the error items generated within a predetermined period.

For example, the error items include the first fatal error, the second fatal error, the third fatal error, the fourth fatal error, the fifth fatal error, the high substrate temperature error, the cell low voltage error, the charging overheat error, the charge overcurrent error, and the high resistance error. Explanatory note for describing the colors corresponding to the error items are displayed next to the donut chart. For example, the color corresponding to the first fatal error is blue, the color corresponding to the second fatal error is red, the color corresponding to the third fatal error is green, and the color corresponding to the fourth fatal error is yellow.

The donut chart is selectable. For example, the user moves the pointer 341 on the screen by operating the mouse (not illustrated) and clicks on a desired donut chart. Alternatively, for example, in a case where the display part 34 is a touch panel, the user touches a desired donut chart. One error item of one battery is selected by selecting one point of a desired donut chart.

Note that, in Modification 1 of the present embodiment, a plurality of error items is displayed as a list by a donut chart, but a plurality of error items may be displayed as a list by a pie chart.

In Modification 2 of the present embodiment, the display part 34 may display a list of the plurality of error items by a table.

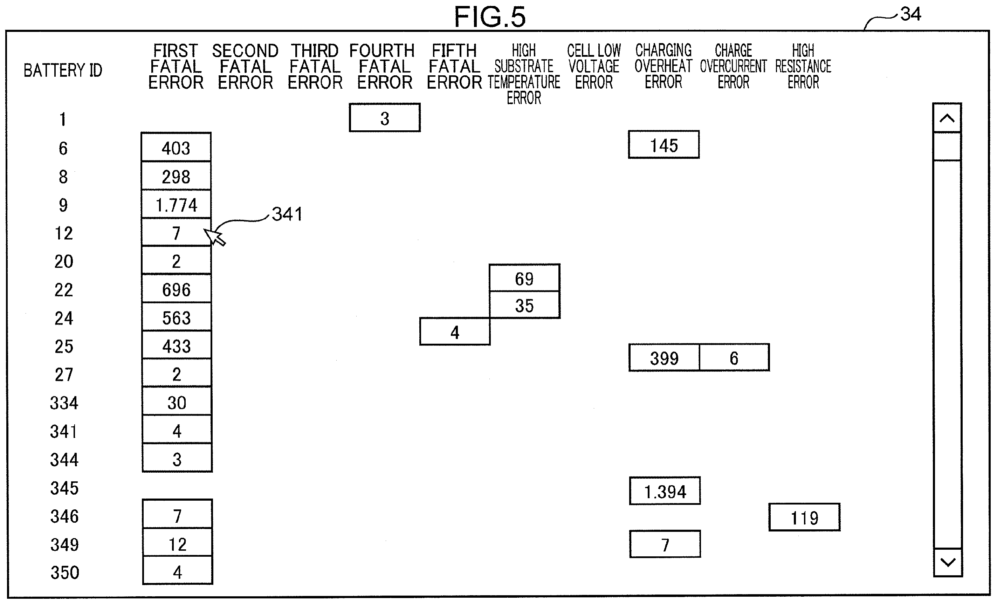

FIG. 5 is a diagram illustrating an example of an error item display screen displaying a list of a plurality of error items in Modification 2 of the present embodiment.

The display part 34 may display the error item display screen illustrated in FIG. 5. The error item display screen includes a table in which the number of occurrence of error of each of the plurality of error items in the predetermined period is associated with the battery ID. A row label item on a vertical axis indicates a battery pack ID, a column label on a horizontal axis indicates an error item, and a value area indicates the number of occurrence of error of each error item within a predetermined period.

For example, the error items include the first fatal error, the second fatal error, the third fatal error, the fourth fatal error, the fifth fatal error, the high substrate temperature error, the cell low voltage error, the charging overheat error, the charge overcurrent error, and the high resistance error. For example, in the battery having the battery ID "1", the number of times of occurrence of the fourth fatal error within a predetermined period is 3, and in the battery having the battery ID "6", the number of times of occurrence of the first fatal error within a predetermined period is 403, and the number of times of occurrence of the charging overheat error within a predetermined period is 145.

The table is selectable. For example, the user moves the pointer 341 on the screen by operating the mouse (not illustrated) and clicks on a desired field on the table. Alternatively, for example, in a case where the display part 34 is a touch panel, the user touches a desired field on the table. One error item of one battery is selected by selecting a desired field.

Referring to FIG. 2 again, next, in step S34, the communication part 31 transmits a data request for requesting a related state item related to one error item of selected one battery to the server 2. The data request includes information (battery ID) indicating one battery selected by the user and information indicating one error item.

Next, in step S25, the communication part 21 of the server 2 receives the data request transmitted by the information terminal 3.

Subsequently, in step S26, the controller 22 executes related state item extraction processing of extracting a related state item indicating a state item related to one error item included in the data request from among a plurality of state items of one battery included in the data request received by the communication part 21. Note that the related state item extraction processing will be described later.

Next, in step S27, the communication part 21 transmits the related state item extracted by the controller 22 and the operation history of all of the plurality of state items of one battery included in the data request to the information terminal 3.

Subsequently, in step S35, the communication part 31 of the information terminal 3 receives the related state item transmitted by the server 2 and the operation history of all of the plurality of state items of one battery.

Next, in step S36, the display part 34 displays the operation history of the related state item received by the communication part 31. Here, the display part 34 displays the operation history of the plurality of state items of one battery, and displays the operation history of the related state item in a different mode from the operation history of other state items other than the related state item.

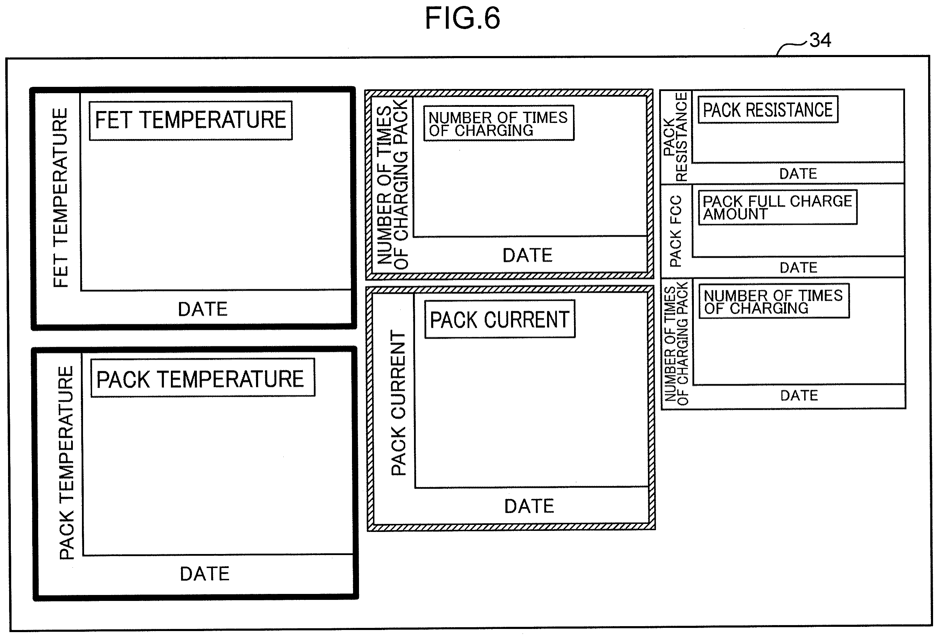

FIG. 6 is a diagram illustrating an example of the related state item display screen displaying the operation history of the related state item in the present embodiment.

The display part 34 displays the operation history of the plurality of state items of one battery, and displays the operation history of the related state item among the plurality of state items in a highlighted manner. In FIG. 6, the FET current, the pack temperature, the number of times of charging, and the pack current are related state items. The pack resistance, the pack full charge amount, and the number of times of charging are other state items. The display part 34 displays the operation history of the related state item in a highlighted manner by surrounding a periphery of the operation histories of these four related state items with a frame of a predetermined color. The predetermined color is, for example, red, and the color of the frame surrounding the operation history of the related state item is different from the color of the frame surrounding the operation history of other state items. The display part 34 may display a frame surrounding the operation history of the related state item to be thicker than the frame surrounding the operation history of other state items.

The related state item includes a first related state item indicating a state item that has caused an error determination, and a second related state item indicating a state item other than the first related state item. The display part 34 may display the operation history of the first related state item and the operation history of the second related state item in different modes. In FIG. 6, the FET current and the pack temperature are the first related state items, and the number of times of charging and the pack current are the second related state items. For example, the display part 34 may display the operation history of the first related state item to be larger than the operation history of the second related state item. For example, the display part 34 may display the color of the frame surrounding the operation history of the first related state item and the color of the frame surrounding the operation history of the second related state item to be different from each other.

Note that the display part 34 may change the order of displaying the operation history of the related state item. For example, the display part 34 may display the operation history of the first related state item in an order prioritizing the operation history of the second related state item. The display part 34 may change the position where the operation history of the related state item is displayed. The display part 34 may change the size of display of the operation history of the related state item.

The display part 34 may display only the operation history of the related state item. The display part 34 may display only the operation history of the first related state item and the second related state item. The display part 34 may set the luminance of the operation history of the related state item to be displayed to be higher than the luminance of the operation history of other state items to be displayed. The display part 34 may set the luminance of the operation history of the first related state item to be displayed to be higher than the luminance of the operation history of the second related state item to be displayed.

In this manner, among the plurality of state items of one battery, not only the operation history of the state item that has caused determination of one error item, but also the operation history of the related state item related to one error item is displayed.

Therefore, the user who is the manager of the plurality of batteries 1 can determine whether the determination result of the error that has occurred in the battery 1 is correct from not only the operation history of the state item that has caused the determination of one error item but also the operation history of the related state item related to the one error item. It is therefore possible to support the user's confirmation as to whether the determination result of the error that has occurred in the battery 1 is correct. Furthermore, since the user can determine the presence or absence of an error that has occurred in the battery 1 other than the one error, it is possible to support the user's analysis of the error that has occurred in the battery 1.

In the present embodiment, the operation history of the related state item related to the one error item is displayed without receiving additional selection from the user for displaying the operation history of the related state item or updating a display content. As a result, in the present embodiment, a processing sequence can be omitted. Therefore, an effect of reducing computer resources is obtained by omitting the processing sequence.

In the present embodiment, in step S27, the communication part 21 transmits the operation history of all of the plurality of state items of one battery included in the data request to the information terminal 3, but the present disclosure is not limited to this configuration. Between step S22 and step S24, or in step S24, the communication part 21 may transmit the operation history of all of the plurality of state items of each of the plurality of batteries 1 to the information terminal 3. In this case, in step S27, the communication part 21 is not required to transmit the operation history of all the plurality of state items of one battery to the information terminal 3. After the selection of one error item by the user is received in step S33, the display part 34 may display the operation history of all of the plurality of state items of one battery. Then, after the related state item is received in step S35, the display part 34 may display the operation history of the related state item among the plurality of displayed state items in a highlighted manner.

Next, the error determination processing of the server 2 in the embodiment of the present disclosure will be described.

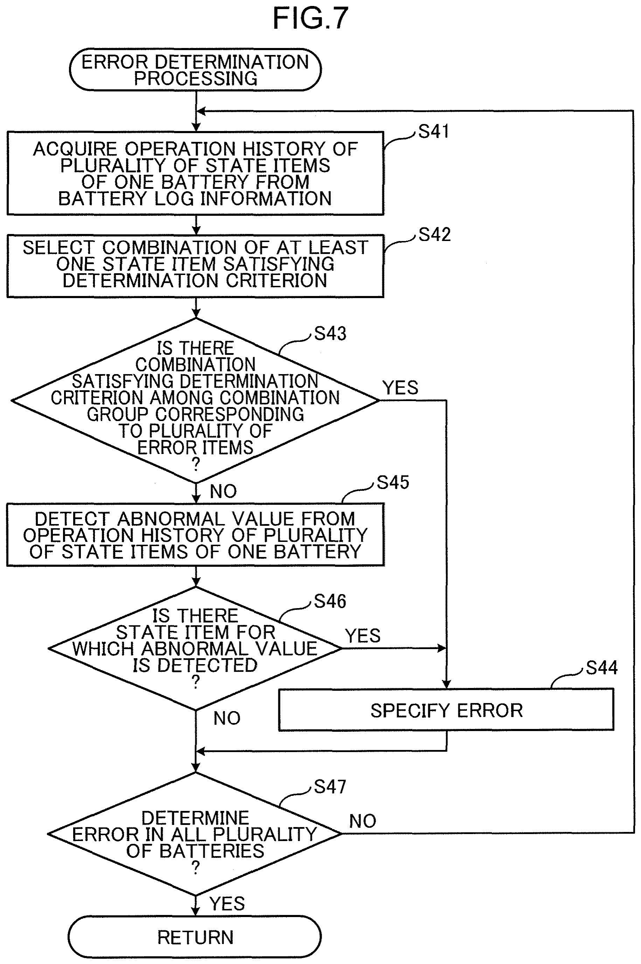

FIG. 7 is a flowchart for describing the error determination processing of the server 2 in the embodiment of the present disclosure.

First, in step S41, the controller 22 of the server 2 acquires the operation history of the plurality of state items of one battery from the battery log information.

Next, in step S42, the controller 22 determines whether each operation history of the plurality of acquired state items satisfies the determination criterion, and selects a combination of at least one state item satisfying the determination criterion. Note that the determination criterion is set for each of the plurality of state items. For example, there is a determination criterion that the operation history is higher than a threshold or lower than a threshold.

Next, in step S43, the controller 22 determines whether there is a combination satisfying the determination criterion in a combination group of at least one state item corresponding to the plurality of error items. Here, when it is determined that there is a combination satisfying the determination criterion in the combination group of at least one state item corresponding to the plurality of error items (YES in step S43), in step S44, the controller 22 specifies an error item corresponding to the combination satisfying the determination criterion as an error that has occurred in one battery.

For example, seven state items of the pack state, he pack current, the cell balance, the pack voltage, the number of times of charging, the cumulative discharge amount, and the system log are used to determine the first to fifth fatal errors. Which one of the first to fifth fatal errors has occurred is determined by a combination of at least one state item satisfying the determination criterion among the seven state items.

When the pack state, the pack current, the cell balance, and the pack voltage satisfy the determination criteria, the controller 22 determines that the first fatal error has occurred in one battery. When the pack state, the pack current, the pack voltage, the number of times of charging, and the cumulative discharge amount satisfy the determination criteria, the controller 22 determines that the second fatal error has occurred in one battery. When the pack state, the pack current, the cell balance, the pack voltage, and the system log satisfy the determination criteria, the controller 22 determines that the third fatal error has occurred in one battery. When the pack state, the number of times of charging, the cumulative discharge amount, and the system log satisfy the determination criteria, the controller 22 determines that the fourth fatal error has occurred in one battery. When the system log satisfies the determination criterion, the controller 22 determines that the fifth fatal error has occurred in one battery.

On the other hand, when it is determined that there is no combination satisfying the determination criterion in the combination group of at least one state item corresponding to the plurality of error items (NO in step S43), in step S45, the controller 22 detects an abnormal value from the operation history of the plurality of state items of one battery.

Next, in step S46, the controller 22 determines whether there is a state item in which an abnormal value is detected among the plurality of state items. Here, when it is determined that there is a state item for which an abnormal value has been detected among the plurality of state items (YES in step S46), in step S44, the controller 22 specifies an error item corresponding to the state item for which an abnormal value has been detected as an error that has occurred in one battery.

For example, when the operation histories of the FET temperature, the pack temperature, the block temperature, and the cell temperature exceed the threshold, the controller 22 determines that the high substrate temperature error has occurred in one battery. For example, when the operation histories of the cell voltage, the pack voltage, and the block voltage exceed the threshold, the controller 22 determines that the cell low voltage error has occurred in one battery. For example, when the operation history of the FET temperature, the pack temperature, the block temperature, and the cell temperature exceeds the threshold, the controller 22 determines that the charging overheat error has occurred in one battery. For example, when the operation histories of the pack current, the block current, and the cell current exceed the threshold, the controller 22 determines that the charge overcurrent error has occurred in one battery. For example, when the operation histories of a pack resistance current and a cell resistance exceed the threshold, the controller 22 determines that the high resistance error has occurred in one battery.

On the other hand, when it is determined that there is no state item for which an abnormal value has been detected among the plurality of state items (NO in step S46), in step S47, the controller 22 determines whether errors have been determined for all the plurality of batteries 1. Here, when it is determined that errors have not been determined for all the plurality of batteries 1 (NO in step S47), the processing returns to step S41, and the controller 22 acquires, from the battery log information, an operation history of a plurality of state items of another battery for which an error determination has not been made from among the plurality of batteries 1.

On the other hand, when it is determined that errors have been determined for all the plurality of batteries 1 (YES in step S47), the error determination processing ends.

Note that, when an error is specified in step S44, the controller 22 may associate a flag indicating that an error has occurred and indicating an error item that has occurred with the battery ID. When it is determined in step S46 that there is no state item for which an abnormal value has been detected, the controller 22 may associate a flag indicating that no error has occurred with the battery ID.

In the present embodiment, the server 2 executes the error determination processing, but the present disclosure is not limited to this configuration, and each of the plurality of batteries 1 may execute the error determination processing. In this case, each of the plurality of batteries 1 may transmit an error item indicating an error that has occurred in the battery 1 to the server 2 together with the battery log information.

Next, the related state item extraction processing of the server 2 in the embodiment of the present disclosure will be described.

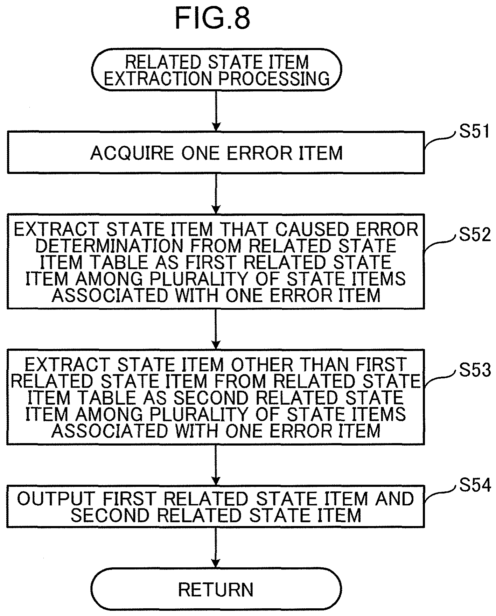

FIG. 8 is a flowchart for describing the related state item extraction processing of the server 2 in the embodiment of the present disclosure.

First, in step S51, the controller 22 acquires one error item included in the data request received by the communication part 21.

Next, in step S52, the controller 22 extracts the state item that has caused the error determination from the related state item table as the first related state item among the plurality of state items associated with the one error item.

Next, in step S53, the controller 22 extracts a state item other than the state item extracted as the first related state item from the related state item table as the second related state item among the plurality of state items associated with the one error item.

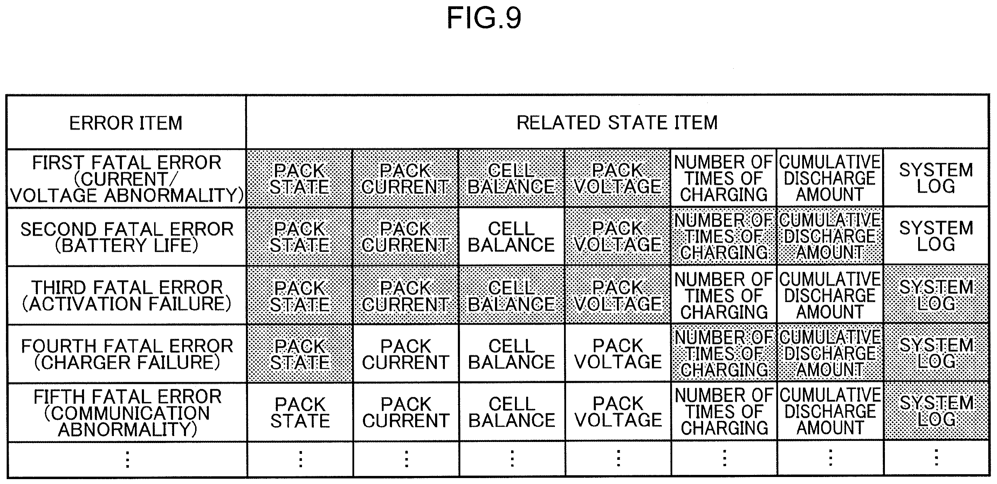

FIG. 9 is a diagram illustrating an example of the related state item table stored in advance in the memory 23 in the present embodiment.

The related state item table is a table in which each of the plurality of error items is associated with the related state item. The related state item includes a plurality of state items used for determination of a fatal error.

In FIG. 9, the row label item on the vertical axis indicates an error item, and the column label on the horizontal axis indicates a related state item related to the error item. The hatched state item represents the first related state item, and the unhatched state item represents the second related state item. The first related state item is at least one state item used for error determination among the plurality of state items associated with the error item. The second related state item is a plurality of remaining state items not used for error determination among the plurality of state items associated with the error item.

The plurality of state items used for determination of a fatal error is determined in advance. At least one state item used for determination of one fatal error among the plurality of fatal errors is also determined in advance.

In the present embodiment, there are five fatal errors, and seven state items are used for determination of the fatal error. A combination of at least one state item satisfying the determination criterion in the error determination processing is at least one state item used for determination of a fatal error. The controller 22 extracts at least one state item used for determination of a fatal error among the plurality of state items used for determination of a fatal error as the first related state item from the related state item table. The controller 22 extracts a plurality of remaining state items not used for determination of a fatal error among the plurality of state items used for determination of a fatal error as the second related state item from the related state item table.

For example, when one error item is the first fatal error, the controller 22 extracts the pack state, the pack current, the cell balance, and the pack voltage that have caused the error determination from the related state item table as the first related state item among the plurality of state items associated with one error item. When one error item is the first fatal error, the controller 22 extracts the number of times of charging, the cumulative discharge amount, and the system log other than the state item extracted as the first related state item from the related state item table as the second related state item among the plurality of state items associated with the one error item.

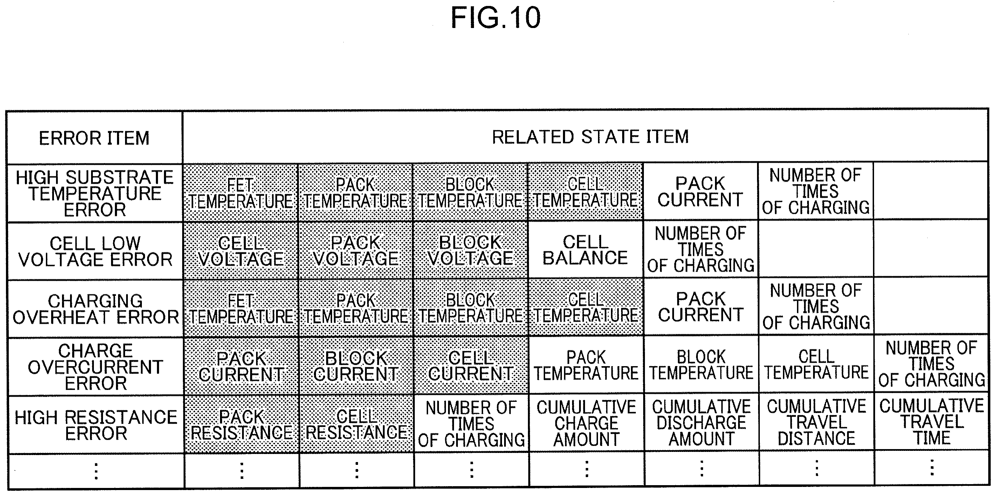

FIG. 10 is a diagram illustrating another example of the related state item table stored in advance in the memory 23 in the present embodiment.

The related state item table is a table in which each of the plurality of error items is associated with the related state item.

In FIG. 10, the row label item on the vertical axis indicates an error item, and the column label on the horizontal axis indicates a related state item related to the error item. The hatched state item represents the first related state item, and the unhatched state item represents the second related state item. The first related state item is at least one state item used for error determination among the plurality of state items associated with the error item. The second related state item is a state item that is not used for error determination but should be checked for analysis among a plurality of state items associated with the error item.

For example, when one error item is the high substrate temperature error, the controller 22 extracts the FET temperature, the pack temperature, the block temperature, and the cell temperature that have caused the error determination from the related state item table as the first related state item among the related state items associated with one error item. When one error item is the high substrate temperature error, the controller 22 extracts the pack current and the number of times of charging other than the state item extracted as the first related state item from the related state item table as the second related state item among the related state items associated with the one error item.

Note that the memory 23 may store the related state item table illustrated in FIG. 9 and the related state item table illustrated in FIG. 10. In this case, the controller 22 may extract the first related state item and the second related state item from the related state item table illustrated in FIG. 9 when one error item is any of a first to fifth fatal errors, and may extract the first related state item and the second related state item from the related state item table illustrated in FIG. 10 when the one error item is any of the high substrate temperature error, the cell low voltage error, the charging overheat error, the charge overcurrent error, or the high resistance error. The memory 23 may store one related state item table in which the related state item table illustrated in FIG. 9 and the related state item table illustrated in FIG. 10 are combined.

Referring to FIG. 8 again, next, in step S54, the controller 22 outputs the first related state item and the second related state item extracted from the related state item table to the communication part 21.

Subsequently, table update processing in the present embodiment will be described.

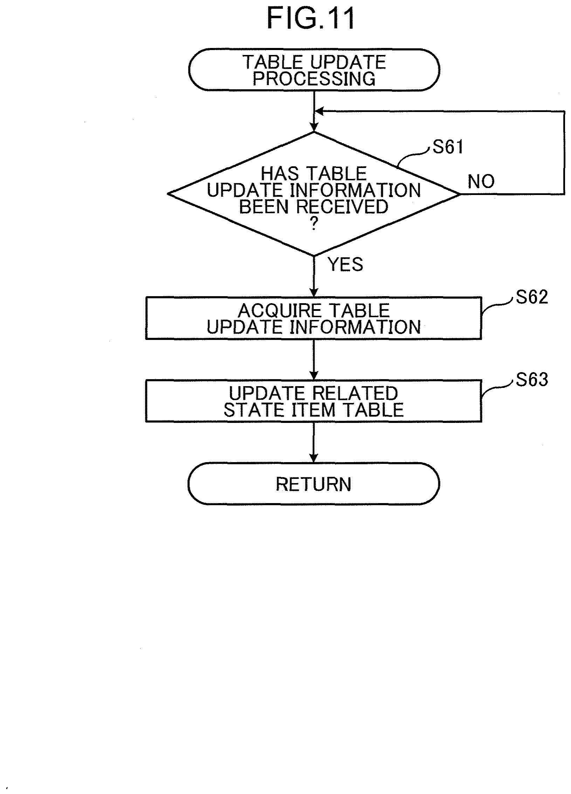

FIG. 11 is a flowchart for describing the table update processing of the server 2 in the embodiment of the present disclosure. Note that the table update processing is performed after the processing of step S27 in FIG. 2.

First, in step S61, the controller 22 determines whether table update information for updating the related state item table has been received. The user may confirm the operation history of the related state item displayed on the display part 34 of the information terminal 3 and determine whether the related state item for one error item is correct. Then, the display part 34 may receive a change by the user of the related state item. The display part 34 receives an input by the user of the state item to be changed and the state item after the change among the displayed related state items. The communication part 31 of the information terminal 3 transmits the table update information including the state item to be changed and the state item after the change to the server 2.

Here, when it is determined that the table update information is not received (NO in step S61), the processing of step S61 is repeated until the table update information is received.

On the other hand, when it is determined that the table update information is received (YES in step S61), in step S62, the controller 22 acquires the table update information received by the communication part 21.

Next, in step S63, the controller 22 updates the related state item table stored in the memory 23 on the basis of the state item to be changed and the state item after change included in the table update information. The controller 22 changes the state item to be changed in the related state item table stored in the memory 23 to the state item after change. Note that the controller 22 may not only rewrite the state item included in the related state item but also delete the state item included in the related state item or add the state item included in the related state item.

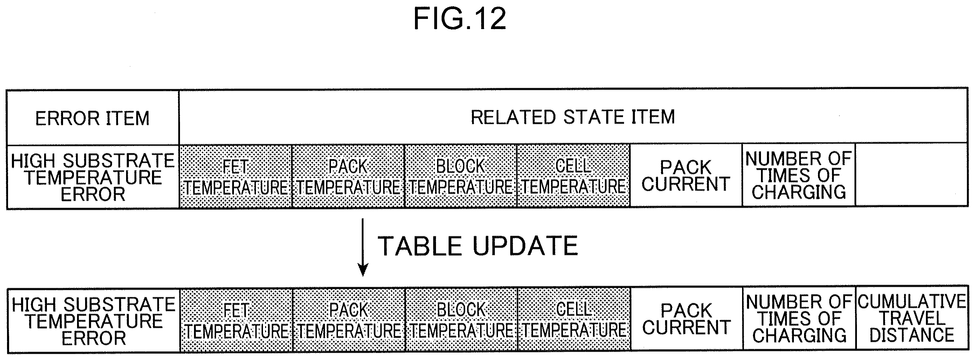

FIG. 12 is a schematic diagram for describing update of the related state item table in the present embodiment.

As illustrated in FIG. 12, in the related state item table before the update, the first related state items of the FET temperature, the pack temperature, the block temperature, and the cell temperature and the second related state items of the pack current and the number of times of charging are associated with the error item of the high substrate temperature error. On the other hand, in the related state item table after the update, the first related state items of the FET temperature, the pack temperature, the block temperature, and the cell temperature and the second related state items of the pack current, the number of times of charging, and a cumulative travel distance are associated with the error item of the high substrate temperature error. In this case, since the user determines that the cumulative travel distance should be further checked as the second related state item for the high substrate temperature error, the cumulative travel distance is added in the related state item table.

In this manner, a user's feedback on the displayed related state item is received and reflected in the related state item table, and thus, the operation history of the related state item related to one error item can be displayed.

Note that a weight value may be associated with a state item included in the related state item in the related state item table, and the controller 22 may extract the related state item in accordance with a magnitude of the weight value associated with the state item. Then, the controller 22 may change the related state item to be extracted by decreasing the weight value of the state item to be changed in the related state item table and increasing the weight value of the state item after change.

Next, the related state item extraction processing of the server 2 in Modification 3 of the present embodiment will be described. The controller 22 of the server 2 may specify another battery similar to one battery among the plurality of batteries 1, and acquire the operation history of the same state item as the related state item among the plurality of state items of the specified another battery. The display part 34 of the information terminal 3 may display the operation history of the related state item, and display the operation history of the state item of another battery same as the related state item of the one battery.

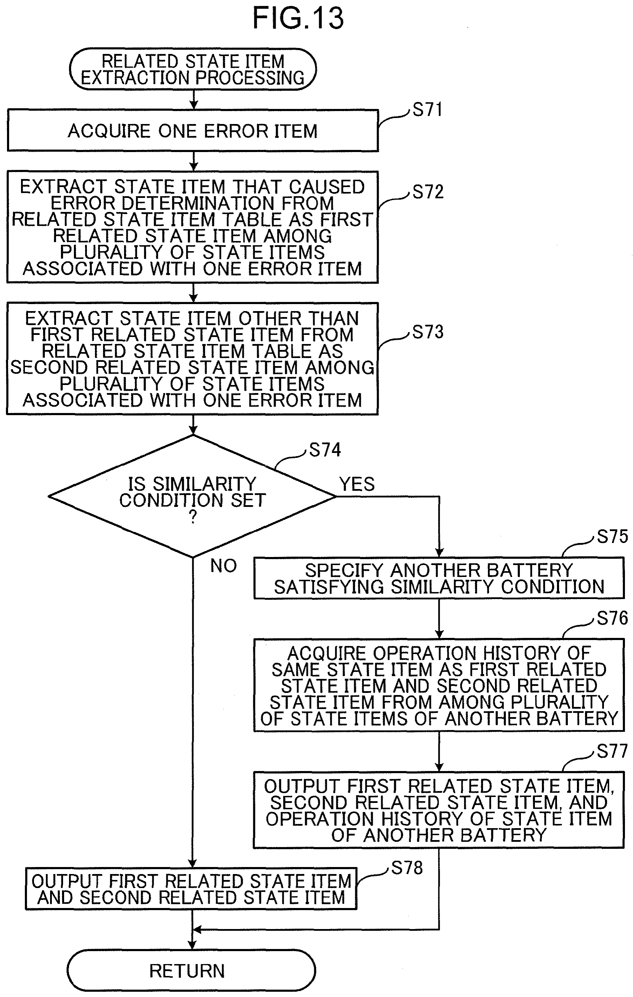

FIG. 13 is a flowchart for describing the related state item extraction processing of the server 2 in Modification 3 of the embodiment of the present disclosure.

The processing of Steps S71 to S73 is the same as the processing of Steps S51 to S53 illustrated in FIG. 8, and will be omitted from description.

Next, in step S74, the controller 22 of the server 2 determines whether a similarity condition for specifying another battery similar to the one battery has been set. The similarity condition is input by the user. Here, when it is determined that the similarity condition has not been set (NO in step S74), the processing proceeds to step S78.

On the other hand, when it is determined that the similarity condition has been set (YES in step S74), in step S75, the controller 22 specifies another battery that satisfies the similarity condition among the plurality of batteries 1. Here, the similarity condition is that an error of the same error item as one battery has occurred or that an error of the same error item as the one battery has occurred in the past.

When the similarity condition is that an error of the same error item as one battery has occurred, the controller 22 specifies a battery in which an error of the same error item as the one battery has occurred as another battery. When the similarity condition is that an error of the same error item as one battery has occurred in the past, the controller 22 specifies a battery in which an error of the same error item as the one battery has occurred in the past as another battery.

Note that one similarity condition may be set, or a plurality of similarity conditions may be set. When a plurality of similarity conditions are set, another battery satisfying the plurality of similarity conditions is specified.

Next, in step S76, the controller 22 acquires an operation history of the same state item as the first related state item and the second related state item among the plurality of state items of the specified another battery.

Next, in step S77, the controller 22 outputs the extracted first related state item and second related state item and the acquired operation history of another battery state item to the communication part 21.

Note that the processing in step S78 is the same as the processing in step S54 illustrated in FIG. 8, and will be omitted from description.

The communication part 21 of the server 2 transmits the operation history of the first related state item, the second related state item, and the state item of another battery output from the controller 22 to the information terminal 3. The communication part 31 of the information terminal 3 receives the operation history of the first related state item, the second related state item, and the state item of another battery transmitted by the server 2. The communication part 31 acquires the extracted first related state item and second related state item and the operation history of the same state item as the first related state item and the second related state item among the plurality of state items of the specified another battery. The display part 34 displays the operation history of the first related state item and the second related state item of one battery, and displays the operation history of the state item of another battery same as the first related state item and the second related state item of the one battery.

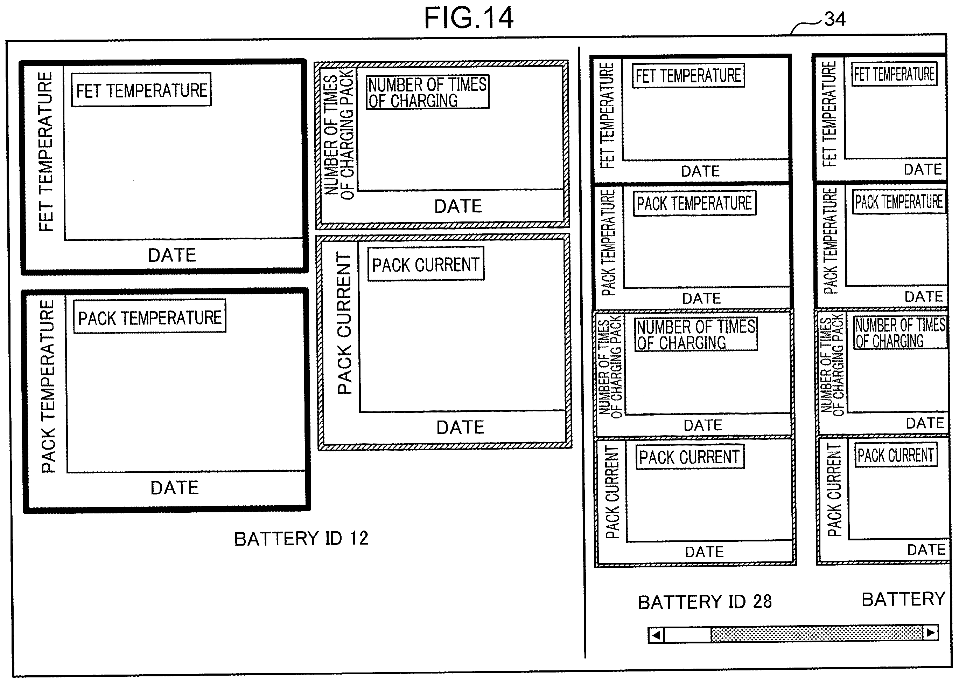

FIG. 14 is a diagram illustrating an example of a related state item display screen displaying an operation history of a related state item in Modification 3 of the present embodiment.

The display part 34 displays the operation history of the related state item of one battery, and displays the operation history of the state item of another battery same as the related state item of the one battery. The display part 34 displays the operation history of the first related state item and the second related state item of one battery, and displays the operation history of the state item of another battery same as the first related state item and the second related state item of the one battery. In FIG. 14, the FET temperature and the pack temperature are the first related state items, and the number of times of charging and the pack current are the second related state items. As another battery similar to one battery having the battery ID "12", a battery having the battery ID "28" or the like is specified.

The display part 34 displays the operation history of the first related state item and the second related state item of the one battery and the operation history of the same state item of another battery as the first related state item and the second related state item of the one battery side by side.

In FIG. 14, the display part 34 displays only the operation history of the first related state item and the second related state item of one battery. The display part 34 displays the operation history of the first related state item and the operation history of the second related state item of one battery in different modes. The display part 34 displays the operation history of the same state item of another battery as the first related state item of one battery and the operation history of the same state item as the second related state item in different modes.

In this manner, another battery similar to one battery is specified, the operation history of the related state item of the one battery is displayed, and the operation history of the state item of the other battery same as the related state item of the one battery is displayed. Therefore, since the operation history of the related state item of one battery can be presented to the user in comparison with the operation history of the state item of the other battery same as the related state item of the one battery, it is possible to support the user's confirmation as to whether the determination result of the error that has occurred in the one battery is correct. In another similar battery, it is possible to support determination by the user as to whether an error similar to the error in one battery occurs, or prediction by the user as to whether there is a possibility that an error similar to the error in the one battery occurs.

Note that, in each of the above embodiments, each constituent element may be implemented by including dedicated hardware or by executing a software program suitable for each constituent element. Each constituent element may be implemented by a program execution part, such as a CPU or a processor, reading and executing a software program recorded in a recording medium such as a hard disk or a semiconductor memory. A program may be recorded onto a recording medium and transferred or transferred via a network, so that the program is performed by another independent computer system.

Some or all functions of the device according to the embodiment of the present disclosure are implemented as large scale integration (LSI), which is typically an integrated circuit. These may be individually integrated into one chip, or may be integrated into one chip so as to include some or all of these. Circuit integration is not limited to LSI, and may be implemented by a dedicated circuit or a general-purpose processor. A field programmable gate array (FPGA), which can be programmed after manufacturing of LSI, or a reconfigurable processor in which connection and setting of circuit cells inside LSI can be reconfigured may be used.

Some or all functions of the device according to the embodiments of the present disclosure may be implemented by a processor such as a CPU executing a program.

All numbers used above are illustrated to specifically describe the present disclosure, and the present disclosure is not limited to the illustrated numbers.

The order in which steps illustrated in the above flowchart are executed is for specifically describing the present disclosure, and may be any order other than the above order as long as a similar effect is obtained. Some of the above steps may be executed simultaneously (in parallel) with other steps.

### Industrial Applicability

The technique of the present disclosure can support the user's confirmation as to whether a determination result of an error that has occurred in the battery is correct, and is useful as a technique of displaying the operation history of the battery in which an error has occurred.

## Claims

1. An information processing method in a computer, the method comprising:
acquiring a plurality of error items indicating an error that has occurred in each of a plurality of batteries determined on a basis of an operation history of a plurality of state items indicating a plurality of states of the plurality of batteries;
when selection of one error item of one battery among the plurality of error items having been acquired is received, acquiring a related state item indicating a state item related to the one error item having been selected from among the plurality of state items of the one battery, and;
displaying an operation history of the related state item having been acquired.

2. The information processing method according to claim 1, further comprising acquiring the operation history of the plurality of state items of the one battery,
wherein in the displaying of the operation history, the operation history of the plurality of state items having been acquired is displayed, and the operation history of the related state item having been acquired is displayed in a mode different from an operation history of another state item other than the related state item.

3. The information processing method according to claim 2, wherein
the related state item includes a first related state item indicating a state item that has caused error determination and a second related state item indicating a state item other than the first related state item, and
in the displaying of the operation history, the operation history of the first related state item is displayed in a mode different from the operation history of the second related state item.

4. The information processing method according to claim 3, wherein in the displaying of the operation history, the operation history of the first related state item is displayed to be larger than the operation history of the second related state item.

5. The information processing method according to claim 3 or 4, wherein in the acquiring of the related state item, from a table in which each of the plurality of error items and a plurality of related state items are associated in advance, the first related state item and the second related state item other than the first related state item among the plurality of related state items associated with the one error item having been selected are extracted, and the first related state item and the second related state item having extracted are acquired.

6. The information processing method according to claim 5, further comprising updating the table to change the current related state item to a new related state item, when a change of the related state item associated with the error item is received.

7. The information processing method according to any one of claims 1 to 4, wherein
in the acquiring of the related state item, another battery similar to the one battery is further specified among the plurality of batteries, and an operation history of a same state item as the related state item is acquired among the plurality of state items of the other battery having been specified, and
in the displaying of the operation history, the operation history of the related state item is displayed, and the operation history of the same state item of the other battery as the related state item of the one battery is displayed.

8. The information processing method according to claim 7, wherein in the specifying of the other battery, a battery in which an error of a same error item as the one battery has occurred or a battery in which an error of the same error item as the one battery has occurred in past is specified as the other battery.

9. An information processing device comprising:
a first acquisition part that acquires a plurality of error items indicating an error that has occurred in each of a plurality of batteries determined on a basis of an operation history of a plurality of state items indicating a plurality of states of the plurality of batteries;
a second acquisition part that, when selection of one error item of one battery among the plurality of error items having been acquired is received, acquires a related state item indicating a state item related to the one error item having been selected from among the plurality of state items of the one battery; and
a display part that displays an operation history of the related state item having been acquired.

10. An information processing program that causes a computer to function to:
acquire a plurality of error items indicating an error that has occurred in each of a plurality of batteries determined on a basis of an operation history of a plurality of state items indicating a plurality of states of the plurality of batteries;
when selection of one error item of one battery among the plurality of error items having been acquired is received, acquire a related state item indicating a state item related to the one error item having been selected from among the plurality of state items of the one battery, and;
display an operation history of the related state item having been acquired.
